# EUROPEAN PATENT APPLICATION

(11) **EP 1 780 780 A2**
(43) Date of publication of application: **02.05.2007**
(21) Application number: 06123197.3
(22) Date of filing: 30.10.2006
(51) Int. Cl.: H01L 21/311

(54) **A plasma composition for the selective etching of high-k materials**

(30) Priority: 28.10.2005 US 731608 P; 23.08.2006 US 839897 P; 22.09.2006 EP 06121143
(71) Applicant: INTERUNIVERSITAIR MICROELEKTRONICA CENTRUM ( IMEC), 3001 Leuven (BE)
(72) Inventor: Shamiryan, Denis, 3001, Leuven (BE); Paraschiv, Vasile, 3010, Kessel-Lo (BE); Demand, Marc, 1350, Jandrain-Jandrenouille (BE)
(74) Representative: pronovem

(57) **Abstract**

The present invention relates to a method for the selective removal of a high-k layer such as HfO₂ over silicon or silicon dioxide.

More specifically a method for etching high-k selectively over silicon and silicon dioxide and a plasma composition for performing said selective etch process is disclosed.

Using a BCl₃ plasma with well defined concentrations of nitrogen makes it possible to etch high-k with at a reasonable etch rate while silicon and silicon dioxide have an etch rate of almost zero.

## Description

### Field of the invention.

The present invention is related to the field of semiconductor processing. More specifically it is related to the patterning of a high-k layer selective over a silicon comprising layer.

The invention is further related to an etch plasma composition and its use for dry etching of a high-k layer selective over a silicon comprising layer such as polycrystalline silicon and SiO₂.

### Background of the invention.

As the critical dimensions in CMOS manufacturing shrink for the 90 nm technology node and beyond, conventional (polycrystalline) silicon gates are being replaced by metal gates (meaning pure metals, metal alloys or metal nitrides, etc) and SiO₂ as a gate dielectric is replaced by materials with higher dielectric constant, so called "high-k" dielectrics. The key challenge is to adapt the conventional gate etch processes to these new materials.

Following deposition and gate patterning, the high-k dielectric material must be removed from the source and drain regions of the transistor. This removal must be accomplished without the loss of any of the underlying silicon, as well as little or no isolation oxide (field oxide) loss.

To date, the most promising dry etch results show a HfO₂ to silicon (HfO₂/Si), as well as a HfO₂ to SiO₂ (HfO₂/SiO₂) etch selectivity no greater than 3:1.

Dilute aqueous hydrofluoric acid (HF) solutions will etch HfO₂ but unfortunately, the etch selectivity of HfO₂ over thermally grown silicon dioxide (TOX) is about 1:10, and the etch selectivity of HfO₂ over tetraethylorthosilicate-based silicon dioxide (TEOS) is about 1:100 for dilute aqueous HF etchants.

Replacing water with a non-aqueous solvent, such as an alcohol, will improve etch selectivity. A HfO₂ to TOX etch selectivity of 3:1 and a HfO₂ to TEOS etch selectivity of 1:1 has been reported (Claes et al., "Selective Wet Etching of Hf-Based Layers," Abstract 549, 204th Meet of Electrochem. Soc., 2003). It can therefore be concluded that there is still a need to improve the etch selectivity of high-k materials such as HfO₂ over silicon and silicon dioxide.

### Aim of the invention.

It is an aim of the present invention to improve the etch selectivity of dry-etch plasmas used to pattern high-k materials containing metal-oxides such as HfO₂ over silicon and silicon dioxide materials.

### Summary.

The present invention relates to a plasma composition used to pattern a high-k comprising stack towards a silicon or silicon dioxide comprising stack with increased selectivity. Said silicon comprising stack can be a polycrystalline Si layer or a doped polycrystalline Si layer.

Furthermore the invention relates to a method for the patterning of a high-k comprising stack. More specifically it relates to the dry etching of high-k layers selectively over silicon and silicon dioxide. Said high-k layer is preferably a metal-oxide layer. A preferred example of said high-k layer is a Hf comprising layer such as a HfO₂ layer but other high-k layers are also disclosed in the present invention.

The present invention solves the problem of the low etch selectivity of high-k materials towards silicon and silicon-dioxide. Examples of high-k layers disclosed in the present invention are HfO₂, ZrO₂, Al₂O₃, La₂O₃, Pr₂O₃, Ta₂O5, TiO₂, Y₂O₃, Pr₂O₃. Said high-k material is preferably a metal-oxide and most preferred said high-k material is HfO₂. The plasmas used in prior art to pattern high-k layers typically have an etch selectivity of 3:1 over silicon and silicon dioxide. Using the method of the invention makes it possible to reach an etch selectivity of high-k materials, such as HfO₂, to silicon and/or silicon dioxide up to 20:1.

The improvement in etch selectivity is based on the surprising effect that using a boron halogen plasma such as a BCl₃ plasma with well defined additions of nitrogen leads to the formation and deposition of a BxNy film onto the silicon surface which reduces the etch rate of said silicon material. Said BxNy film is deposited onto the silicon and/or silicon dioxide and not on the high-k material (e.g. HfO₂).

More specifically a boron-halogen comprising plasma with additions of nitrogen for selective etching of at least two materials is disclosed by the present invention whereby the etch rate of the first material is reduced to almost zero by depositing a protective BxNy comprising layer onto the surface of said first material such that the etch rate of said first material drops down to zero and whereby deposition of said BxNy layer onto the second material is avoided.

The preferred boron-halogen compound used to perform the invention is BCl₃. The preferred addition of nitrogen to said BCl₃ plasma is lower than 15% of the total plasma composition.

In a preferred embodiment, the first material is silicon and the second material is a high-k material. The preferred addition of nitrogen is lower than 15% and more preferred above 5% and most preferred the addition of nitrogen is 10% of the total plasma composition.

More preferred, the first material is undoped polycrystalline silicon (poly-Si) or doped or polycrystalline silicon (poly-Si).

More preferred the second material is HfO₂.

Preferably the first and second materials are part of a gate stack in a semiconductor device.

Alternatively the first material and second material are part of a Non-Volatile Memory (NVM) device.

In another preferred embodiment, the first material is silicon dioxide and the second material is a high-k material.

The preferred addition of nitrogen is lower than 15% and more preferred above 10% and most preferred in the range of 10% up to 13% of the total plasma composition.

More preferred the second material is HfO₂.

Preferably the first and second materials are part of a gate stack in a semiconductor device. Alternatively the first material and second material are part of a Non-Volatile Memory (NVM) device.

In the preferred embodiments of the invention, the plasma composition further comprises an inert compound. The addition of an inert compound (meaning that these compounds do not react with the substrate to be etched such that volatile compounds are formed) can improve the dissociation rate in the plasma and improve the formation (deposition) of a BxNy film. In that case the inert compound can be seen as a catalyst.

In case the plasma of the invention comprises beside BCl₃ and nitrogen other compounds such as inert compounds, the ratio of BCl₃ towards nitrogen is important.

In case the first material is silicon dioxide and the second material is a high-k material (e.g. HfO₂), the preferred ratio of nitrogen towards BCl₃ is lower than 1:5,6 and more preferred above 1:9 and most preferred in the range of 1:9 up to 1:6,7.

In case the first material is silicon and the second material is a high-k material (e.g. HfO₂), the preferred ratio of nitrogen towards BCl₃ is lower than 1:5,6 and more preferred above 1:19 and most preferred the ratio of nitrogen towards BCl₃ is 1:9.

In the preferred embodiments of the invention, the protective BxNy layer can be removed during etching (using said plasma composition) by means of ion bombardment.

More preferred said ion bombardment is achieved by using a substrate bias during plasma etching which is different from zero. Most preferred said substrate bias during plasma etching is in the range of -30v and -60V.

In the preferred embodiments of the invention, the protective BxNy layer can be (alternatively) removed after etching by means of a wet rinse (e.g. by means of a water rinse).

In yet another preferred embodiment of the invention, the protective BxNy layer is removed by a combination of a first removal step during etching by means of ion bombardment using a substrate bias different from zero and a second removal step performed after etching by means of a wet rinse (e.g. by means of a water rinse).

Preferably, the power in the etch chamber (in the chamber where a method of the invention is carried out) is in the range of 100W up to 1200W. More preferred the power in the etch chamber is around 450W.Preferably, the plasma of the present invention (during patterning) has a pressure in the plasma chamber of minimum 0.666 Pa (5mT) and maximum 10.665 Pa (80mT). More preferred said pressure is 0.666 Pa (5mT).

Preferably, the plasma of the present invention (during patterning) has a temperature below 100°C and most preferred said plasma temperature during dry-etch patterning is around 60°C.

Furthermore, a method is disclosed in the present invention for etching a second material selective over a first material, said method comprising the steps of first applying a dry-etch step using a plasma whereby during the etching a protective and water-soluble film is deposited onto the first material such that the etch rate of said first material is dropped to almost zero and whereby almost no protective and water-soluble film is deposited onto the second material. Subsequently, said protective film is removed from the first material.

The present invention also relates to the use of a plasma comprising (or consisting of) BCl₃, to which nitrogen is added to reach 10% to 15% of the total volume of the resulting plasma composition, for selectively etching a (suitable) stack of layer (i.e. comprising at least one layer etchable by said BCl₃ component, in particular a metal-oxide layer, and more particularly a metal-oxide layer to be used as high-k material in a device) selectively over a silicon or silicon-dioxide layer. More preferred the addition of nitrogen is above 10% and most preferred in the range of 10% up to 13% of the total plasma composition.

Said use is particularly useful for (patterning) a stack of layers in a device wherein at least one layer is a high-k layer which needs to be etched selectively over a silicon or silicon dioxide layer.

Most preferred said high-k layer is a metal oxide such as HfO₂.

Most preferred said device is a semiconductor device in which a gate stack needs to be patterned.

Alternatively and also preferred said device is a Non Volatile Memory device.

More specifically, a reactive ion etching (RIE) method is provided for selectively removing a high-k material layer from a silicon (e.g. poly-Si, possibly doped) or silicon dioxide layer with a plasma composition according to the invention.

More particularly, said plasma composition comprises (or consists of) BCl₃ and nitrogen in a volume ratio N₂/BCl₃ comprised between (about) 1:19 and (about) 1:5,6.

Preferably, the plasma composition temperature for etching is less than (about) 100°C, preferably less than (about) 90°C, more preferably less than (about) 80°C, even more preferably less than (about) 70°C, and even more preferably is (about) 60°C.

In a RIE method according to the invention, wherein said plasma composition can further comprise helium or preferably argon.

Preferably, said plasma composition consists of argon, BCl₃ and nitrogen, wherein the ratio N₂/BCl₃ is comprised between (about) 1:19 and (about) 1:5,6.

Preferably, said argon or helium is added up to 50 vol.%, based on the total volume of the plasma composition.

In a RIE method according to the invention, a bias (or substrate bias) is applied to said silicon or silicon dioxide layer. Said bias is preferably comprised between -30V and -60V.

Preferably, in a RIE method according to the invention, the plasma power is comprised between 100W and 1200W, more preferably is about 450W.

Preferably, the pressure in the chamber is comprised between 0.666 Pa (5mT) and 10.665 Pa (80mT), more preferably is about 0.666 Pa (5mT).

Preferably, in a RIE method according to the invention, said high-k material layer is a metal oxide layer suitable for an integrated circuit or a semiconductor device. Preferably, said metal oxide is selected from the group consisting of HfO₂, ZrO₂, Al₂O₃, La₂O₃, Pr₂O₃, Ta₂O5, TiO₂, Y₂O₃, and Pr₂O₃. More preferably, said metal oxide is HfO₂.

By carrying out a RIE method of the invention for selectively removing said high-k material layer, a passivating boron-nitride-like film (preferably, the three major components of said film being boron, nitrogen and oxygen) is deposited, during the etching, on said silicon (e.g. poly-Si, possibly doped) or silicon dioxide layer underneath, protecting said silicon or silicon dioxide layer (i.e. etch rate substantially reduced).

A method for the manufacture of a semiconductor device, in particular a NVM device, is also provided, comprising the steps of:
- providing a silicon (e.g. poly-Si) or SiO₂ substrate,
- depositing a high-k material layer on said substrate,
- forming a patterned gate electrode on said high-k material layer, and
- anisotropically etching said high-k material according to a RIE method of the invention.

Preferably, in a manufacturing method according to the invention, said patterned gate electrode comprises a germanium layer. By carrying out a method of the invention, a passivating boron-nitride containing film is deposited on the sidewalls of said germanium layer, protecting the vertical profile of said gate electrode. More particularly, said boron-nitride containing film deposited on the sidewalls of said germanium layer is water soluble.

Preferably, a manufacturing method according to the invention further comprises a wet rinsing step, preferably a water rinsing step.

Preferably, said semiconductor device is formed on a semiconducting substrate selected from the group consisting of group IV materials, like silicon, or group III-V compounds, like gallium arsenide, or structured substrate such as silicon-on-insulator, strained silicon and silicon-germanium, or mixtures of such materials.

More preferably, said semiconductor device is a NVM device.

### Short description of the drawings.

All drawings are intended to illustrate some aspects and embodiments of the present invention. Not all alternatives and options are shown and therefore the invention is not limited to the content of the given drawings.

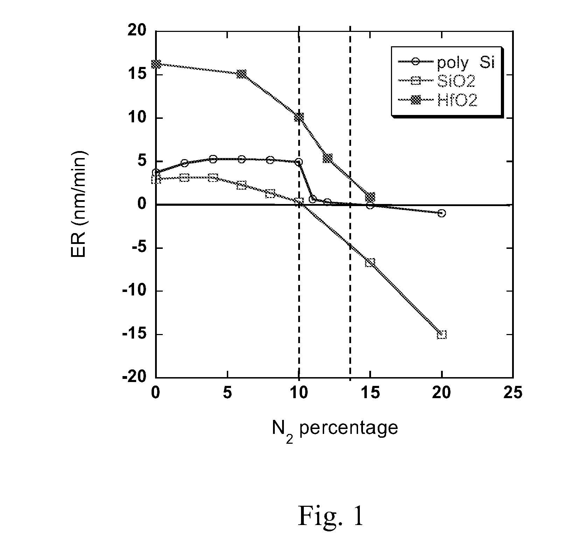

Figure 1 illustrates the etch rate of HfO₂, SiO₂ and poly-silicon (poly Si) using a BCl₃ plasma with increasing additions of nitrogen. One can see that at a certain concentration of nitrogen the etch rate of poly silicon and the etch rate of SiO₂ become negative. This nitrogen concentration where the etch rate of poly silicon and the etch rate of SiO₂ become negative corresponds to the point where the boron-nitride containing film is deposited quicker than removed. The optimum concentration of nitrogen added to the total plasma composition (in this case pure BCl₃/N₂ plasma) is indicated in the graph (i.e. about 10% N₂ to about 13, 5% N₂).

Figure 2 shows the etch selectivity of HfO₂ to silicon and the etch selectivity of HfO₂ to SiO₂. The etch selectivity is expressed as the etch rate of HfO₂ divided by the etch rate of SiO₂ in a pure BCl₃/N₂ plasma.

Figure 3 shows a Ge gate profile after high-k removal by pure BCl₃ plasma for 10 seconds (Figure 3A) and BCl₃/N₂ (10% N₂) plasma for 20 seconds (Figure 3B) .

Figure 4 shows FTIR (Fourier Transform Infrared Spectroscopy) spectra of films deposited from BCl₃/N₂ plasma mixture (70% BCl₃) at 275°C and 60°C.

### Description of the invention.

In the context of the present invention, the term poly-Si refers to Polycrystalline Silicon, which is a form of silicon composed of many crystals and is widely used as gate electrode in a semiconductor device. The poly-Si can be further doped to increase its performance.

In the context of the present invention, the term "substrate bias" refers to the voltage applied to the substrate in a Reactive Ion Etching (RIE) chamber. This value is expressed in Volt (as a negative number). The absence of substrate bias (Bias = 0) gives substantially no ion bombardment meaning almost no etching behavior.

In the context of the present invention, the terms "sacrificial layer", "protective layer", "passivation layer", and "passivating layer" as used in the text refer to the boron-nitride-like film (also referred to as boron-nitride containing film, BxNy film, or BxNy like film) which is deposited during etching using a plasma comprising (or consisting of) BCl₃ and N₂ according to the invention. Said BxNy film is used as a "protective" or "passivating" film during patterning/etching of a structure, said BxNy film is also referred to as a sacrificial layer because said layer is preferably removed during (simultaneously) or after etching. During etching the BxNy film can be removed (completely or partly) by tuning the substrate bias: by providing sufficient ion bombardment the BxNy film can be (partly or completely) removed. After etching said BxNy film (or remaining BxNy film) can be removed by a water rinse due to the unstable and water-soluble character of the BxNy film.

In the context of the present invention, the term "selectivity" refers to the higher etch rate of a selected material compared to the etch rate of another material.

In the context of the present invention, the term "ratio" is expressed as amount of a first compound to a second compound, e.g. a ratio of 9:1 means e.g. 9 sccm (standard centimeter cube per minute) of the first compound and 1 sccm of the second compound.

In the context of the present invention, the term "anisotropic etch" refers to the etching wherein the etch rate is much higher in the direction perpendicular to the surface (or substrate) than in the direction parallel to the surface (or substrate). This in contrast to "isotropic etch" wherein the etching occurs at the same rate in any direction or being non-directional.

In the context of the present invention, the term "high-k" refers to a dielectric constant of a dielectric material higher than the dielectric constant of silicon dioxide (i.e. k>3, 9) .

The present invention relates to a plasma composition for selective anisotropic dry-etching of at least two materials whereby the etch rate of the first material is reduced to almost zero by depositing a protective layer during etching onto the surface of said first material such that the etch rate of said first material drops down to zero and whereby deposition of said protective layer onto the second material is avoided.

More specifically, the present invention discloses a composition of a plasma optimized to etch a high-k material with improved selectivity towards silicon and silicon dioxide materials.

Said dry-etching method is an anisotropical dry-etching method and said high-k material is preferably a metal-oxide and most preferred said high-k material is HfO₂.

The plasma used in prior art to pattern a high-k layer (e.g. HfO₂) is typically a (pure) BCl₃ plasma.

The metal-oxide in question can be etched by said BCl₃ plasma (in contrary to a Cl₂ plasma) by formation of volatile BOClₓ compounds thereby eliminating the need of a breakthrough step if the metal to be etched is a metal-oxide.

The metal in question (e.g. Hf) can be etched further by means of the BCl₃ plasma forming volatile halides (e.g. HfCl₄).

The BCl₃ plasma typically has an etch selectivity of 3:1 for HfO₂ over silicon and silicon dioxide.

The plasma of the invention solves the problem of a too low etch selectivity by adding a well defined amount of nitrogen to the BCl₃ plasma.

The etch rate of silicon and silicon dioxide is decreased due to the formation and deposition of BxNy polymers onto the silicon and silicon dioxide surface and not onto the high-k layers (at least not in the same degree).

Said BxNy film can be removed simultaneously during etching by ion bombardment which has as consequence a significant drop down in etch rate.

The improvement in etch selectivity (etch selectivity of the high-k layer over silicon or silicon dioxide) of said BCl₃ plasma is achieved by adding a well defined concentration of nitrogen to the BCl₃ plasma. Said concentration of nitrogen is preferably lower than 15% nitrogen to the total plasma composition and more preferred in the range of 10% up to 13% nitrogen to the total plasma composition.

By adding nitrogen to the BCl₃ plasma, a boron-nitride comprising by-product is formed. Said boron nitride compound is deposited on the silicon by forming a Si-B bonding since silicon itself is not forming a volatile compound with BCl₃. In case a silicon dioxide substrate is present, the oxide is first removed by the BCl₃ plasma through the formation of BOClₓ such that the Si becomes available to form the Si-B bonding.

For silicon and silicon dioxide the improvement in etch selectivity is in the order of a factor 4 to 7 compared to the original etch selectivity.

In case the high-k layer is HfO₂, and the silicon comprising layer is poly-Si, the concentration of nitrogen is preferably above 10% nitrogen. The most preferred concentration of nitrogen to the total plasma composition which also gives a reasonable etch rate for the HfO₂ layer is in the range of 10% up to 13% nitrogen to the total plasma composition.

In case the high-k layer is HfO₂, and the silicon comprising layer is silicon dioxide, the concentration of nitrogen is preferably above 5% and more preferred said concentration of nitrogen is 10% to the total plasma composition.

The plasma can further comprise an inert compound but this is not necessary to achieve the effect of depositing the BxNy film. Said inert compound can be e.g. argon (Ar) or helium (He) and this compound can be added to the plasma in concentrations up to 50% of the total plasma composition. The addition of an inert compound (meaning that these compounds do not react with the substrate to be etched such that volatile compounds are formed) can improve the dissociation rate in the plasma and hence improve the etch rate and more specifically in case of the invention improve the formation (deposition) of a BxNy film. In that case the inert compound can be seen as a catalyst.

In case the plasma of the invention comprises beside BCl₃ and nitrogen other compounds such as inert compounds, the ratio of BCl₃ towards nitrogen is important.

In case the first material is silicon dioxide and the second material is a high-k material (e.g. HfO₂), the preferred ratio of nitrogen towards BCl₃ is lower than 1:5,6 and more preferred above 1:9 and most preferred in the range of 1:9 up to 1:6,7.

In case the first material is silicon and the second material is a high-k material (e.g. HfO₂), the preferred ratio of nitrogen towards BCl₃ is lower than 1:5,6 and more preferred above 1:19 and most preferred the ratio of nitrogen towards BCl₃ is 1:9.

Application of a well defined BCl₃/N₂ comprising (or consisting) plasma results in the deposition of a BxNy-like film onto the silicon comprising substrate during the etching of the high-k material. Said film can be destroyed using ion bombardment. Said ion bombardment can be tuned in the plasma during high-k etch by tuning the substrate bias or in other words tuning the voltage applied to the substrate during etching. Said substrate bias is typically expressed as a negative value and lowering the substrate bias will lead to a higher etch selectivity of high-k material over silicon comprising materials. The substrate bias is different from zero and preferably in the range of -30V and -60V.

The invention discloses the surprising effect of the selective deposition of a BxNy film during the etching of a structure using a BCl₃/N₂ comprising plasma. Said BxNy film will deposit differently onto different kind of materials which makes it suitable to tune etch rate of different materials relative to each other. Said BCl₃/N₂ comprising plasma has well defined amount of nitrogen. The deposition of said BxNy film is performed in a plasma etch chamber (e.g. Versys 2300 etch chamber from LAM^{®}) at low temperatures (e.g. 60°C) that was never reported before (BN deposition usually performed at temperatures in the range 390°C-650°C). The BxNy film can deposited at a rate as high as e.g. 300 nm/min depending on the pressure, plasma power, gas flows and plasma composition (more specifically the BCl₃ to N₂ ratio). Said deposited BxNy-like film was found to be easily decomposing by temperature (the film thickness decreases at temperatures above 100°C) and soluble in water at room temperatures.

It is further an object of the present invention to provide a method for the dry etching of non-silicon comprising layers such as high-k materials (e.g. HfO₂) selectively over Si comprising layers such as Si (e.g. poly-Si) and/or Silicon-dioxide.

The present invention solves the problem of insufficient selectivity using a dry-etch plasma whereby a protective layer is deposited onto the silicon comprising layer(s) during dry-etching and whereby almost no deposition of said protective layer is obtained onto the non-silicon-containing layers such as a HfO₂ layer. Due to the deposition of a protective layer onto the silicon-comprising layer(s), the etch rate of said silicon-comprising layers is decreased. Said protective layer is preferably a BxNy film which is deposited during etching as a by-product onto the silicon-comprising layer(s), said plasma used is preferably a BCl₃/N₂ comprising plasma whereby the amount of nitrogen added to the BC13 is a well defined concentration such that the etch selectivity of the non-silicon-containing high-k layers over the silicon-comprising layer(s) is increased significantly. Depending on the further etch parameters such as substrate bias, said protective BxNy film can be removed simultaneously during etching.

The invention discloses a method to pattern a high-k comprising stack of layers selectively over a silicon or silicon-dioxide layer (or substrate). Said patterning is an anisotropic dry-etching. Most preferred said stack of layers are gate stack layers. Said stack of layers is situated or deposited onto a substrate. Most preferred said substrate is a silicon (Si) comprising substrate. The aim of the patterning is to pattern or to form a gate structure in said gate stack layers. Said gate structure comprises at least one gate electrode (layer) and at least one gate oxide or high-k (layer) situated below said gate electrode layer. More specifically the invention relates to the selective etching (or patterning) of the gate oxide layer (also referred to as high-k layer) towards the Si substrate.

The substrate bias is a critical parameter to achieve the desired effect of the invention. Most preferred the substrate bias is such that there is still a reasonable etch rate achieved for the removal of high-k (said high-k material defined as a metal-oxide such as e.g. HfO₂) and such that the etch rate of a silicon (or Ge) comprising layer is reduced to a minimum (or almost zero) due to the simultaneous deposition of a BxNy film onto the Si (or Ge) comprising layer.

The substrate bias is different from zero and preferably in the range of -30V and -60V.

In the ideal case, and most preferred, the removal of the BxNy film should be achieved by ion bombardment (by tuning the substrate bias to the corresponding value). Said ion bombardment (substrate bias value) should be such that almost a complete removal of the BxNy film is achieved and almost no removal of the Si (or Ge) is seen.

An additional positive effect can be obtained when using the method of the invention. Said additional effect is taking place simultaneously when applying the method of the invention to improve the etch selectivity of a high-k layer. Said effect is characterized as preserving existing vertical profiles and keeping the critical dimension of the vertical structure intact.

As an example it can be illustrated to the case whereby above the high-k layer a vertical structure is already present and whereby the material of said structure is very sensitive to a BCl₃ plasma leading to damage and distortion of the vertical profile (e.g. lateral attack by the BCl₃ plasma used to etch the high-k layer). As an example the method of the invention can be used to etch a stack comprising e.g. a germanium (Ge) structure (vertical profile) on top of the high-k layer whereby lateral attack of the Ge profile due to the aggressive BCl₃ plasma needs to be avoided. The addition of 10-15% nitrogen will preserve the vertical profile due the deposition of a protective BxNy layer which is deposited during etching. Said protective BxNy layer can be easily removed after etching by means of water due to the water-soluble character of the BxNy layer.

Furthermore, the plasma disclosed can be used to preserve the vertical profile of already existing vertical structures through the formation of a passivating BxNy-like layer on the vertical surfaces.

The invention also relates to the use of a boron-halogen based plasma, in particular a BCl₃ based plasma, with small additions of nitrogen for the selective etch of high-k towards silicon and silicon dioxide.

In particular, the present invention provides an anisotropical etching method, in particular a reactive ion etching method, for selectively removing a high-k material layer from a silicon (e.g. poly-Si) or silicon dioxide layer with a plasma composition according to the present invention, and in particular with a plasma composition comprising (or consisting of) BCl₃ and nitrogen in a ratio N₂/BCl₃ comprised between (about) 1:19 and (about) 1:5,6.

Preferably, the plasma composition temperature for etching is less than (about) 100°C (or the chamber temperature during etching is less than (about) 100°C).

Preferably, said plasma composition to be used in a method of the invention further comprises helium or more preferably argon. Preferably, said argon or helium is added up to 50 v.%, based on the total volume of the plasma composition.

More particularly, said plasma composition consists of BCl₃ and nitrogen in a ratio N₂/BCl₃ comprised between (about) 1:19 and (about) 1:5,6 and argon.

Preferably, said high-k material layer is a metal oxide layer suitable for an integrated circuit or a semiconductor device. More particularly, said metal oxide is selected from the group consisting of HfO₂, ZrO₂, Al₂O₃, La₂O₃, Pr₂0₃, Ta₂O5, TiO₂, Y₂O₃, and Pr₂O₃.

A preferred high-k material is HfO₂.

A method of the invention can be used for the manufacture of "integrated circuits" or "semiconductor devices", including devices formed on semiconducting substrates, such as group IV materials like silicon or group III-V compounds like gallium arsenide, or structured substrate such as silicon-on-insulator, strained silicon and silicon-germanium, or mixtures of such materials. Also included are all types of devices formed, such as memory and logic, and all designs of such devices, such as MOS and bipolar. Further applications are flat panel displays, solar cells, and charge coupled devices.

Preferably, a method of the invention is used for the manufacture of a NVM device.

A method of the invention for the manufacture of a semiconductor device, in particular a NVM device, can comprise the steps of:
- providing a silicon (e.g. poly-Si) or SiO₂ substrate,
- depositing a high-k material layer on said substrate,
- forming a patterned gate electrode on said high-k material layer, and
- anisotropically etching according to a method of the present invention, e.g. for removing said high-k material layer from the source and drain regions.

Preferably, said high-k material layer is a metal oxide layer suitable for said semiconductor device. More particularly, said metal oxide is selected from the group consisting of HfO₂, ZrO₂, Al₂O₃, La₂O₃, Pr₂O₃, Ta₂O5, TiO₂, Y₂O₃, and Pr₂O₃.

A preferred high-k material is HfO₂.

In a method of the invention for the manufacture of a semiconductor device, said patterned gate electrode can comprise a germanium layer, the vertical profile of which is protected by the BxNy passivating film. The method can then further comprise a step of removing said passivating film, more particularly a wet rinsing step (preferably by means of water).

### EXAMPLES

### Example 1: Application of BCl₃/N₂ used to HfO₂ selectively over Si substrate underneath

The BCl₃/N₂ plasma of the invention was used to pattern a gate structure having a high-k material (in the presented case the high-k dielectric is HfO₂). The high-k dielectric must be removed selectively to the underlying Si substrate. The gate stack further comprises Germanium on top of said high-k.

Using the plasma of the invention, a BCl₃/N₂ plasma the HfO₂ can be removed selectively over the silicon. Preferably the amount of nitrogen in the BCl₃/N₂ plasma is 10% nitrogen to the total plasma concentration.

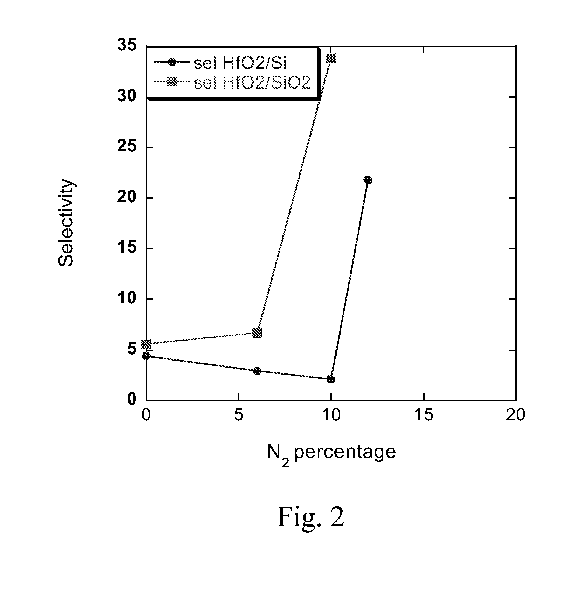

A further advantage of using the BCl₃/N₂ plasma is this example is the fact that Ge gate profile just after patterning and before high-k removal as shown in Figure 2 is straight and no lateral attack due to the BCl₃ plasma is seen because a protective BxNy layer is deposited onto the sidewalls of said Ge structure during the removal of high-k.

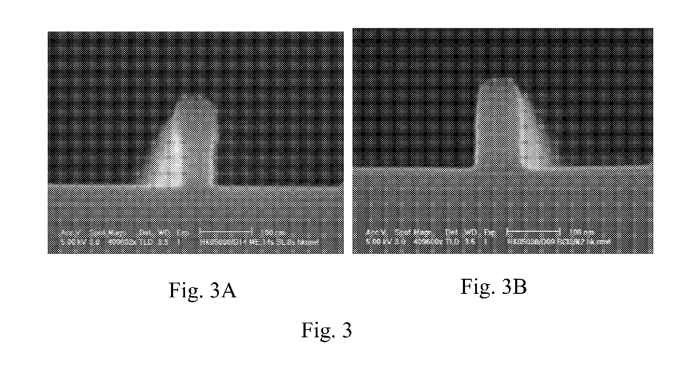

Figure 3A shows the Ge gate profile after high-k removal by a pure BCl₃ plasma for 10 seconds and Figure 3B shows the Ge gate profile after high-k removal by a BCl₃/N₂ (10% N₂) plasma for 20 seconds. No lateral attack of the Ge profile is seen in Figure 3B.

The optimal plasma parameters used for the deposition of a BxNy passivation film during high-k removal in a Ge gate stacks as presented in example 2 can be as follows:
Pressure 5 mT (within range 5mT-80mT),
plasma power 450W (within range 100-1200W),
substrate bias -30V,
BCl₃ 90 sccm (standard centimeter cube per minute), N₂ 10 sccm.

It can be concluded that addition of small amounts of N₂ (in the presented case 10% N₂ was added) to the BCl₃ plasma during high-k removal gives beside an increase in etch selectivity of HfO2 over silicon by a factor 7 it further preserves the shape of the Ge gate. This is due to the deposition of a BxNy-like passivation film on the gate (vertical) sidewalls. Said BxNy-like passivation film is a sacrificial layer which can be removed afterwards by wet treatment.

### Example 2: Characterization of the deposited BxNy layer

Using the plasma composition (BCl₃/N₂) and method of the present invention resulted in the deposition of a BxNy layer. Said BxNy film was characterized by Fourier Transmission Infra-Red spectrometry (FTIR) and X-ray Photoelectron Spectroscopy (XPS). It was found that a plasma mixture of BCl₃ and N₂ resulted in the deposition of a BxNy film onto a (flat) wafer surface if no bias was applied to the substrate (to avoid ion bombardment). Said BxNy film was deposited in an etch chamber (LAM Versys 2300) at 60°C and 275°C at a rate as high as 300 nm/min depending on the pressure, plasma power, gas flows and BCl₃ to N₂ ratio.

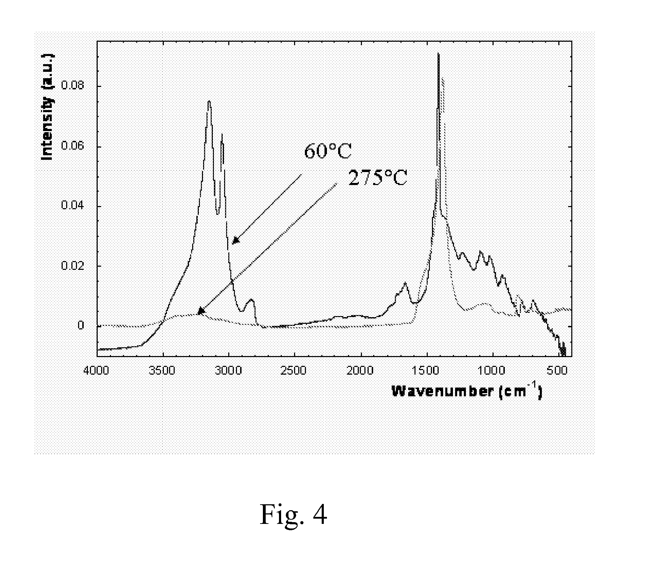

The FTIR spectra of the BxNy films deposited at 60°C and 275°C (for comparison) are shown in Figure 4. A strong peak at about 1400 cm⁻¹ is attributed to a hexagonal boron nitride (h-BN). This peak dominate the spectrum of the film deposited at 275°C but the spectrum of the film deposited at 60°C contains number of other peaks and, therefore, that film is not pure BN.

The XPS analysis of the surface of the film deposited at 60°C showed primarily boron (about 36%), nitrogen (about 20%) and oxygen (about 36%). Some carbon (about 7%) is attributed to the contamination from the atmosphere. The amount of chlorine did not exceed 1%. As the deposition plasma contains no O₂, the significant amount of oxygen in the film is a sign of the film oxidation during the atmosphere exposure.

The deposited BxNy-like film was found to be easily decomposing by temperature (the film thickness decreases at temperatures above 100°C) and soluble in water at room temperatures. These properties make cleaning of any deposited inhibitor layer easy: the water rinse is enough to clean any BxNy-like film that is left after the etching.

It can be concluded that by mixing BCl₃ and N₂ in a plasma etch chamber it is possible to deposit a BxNy-like film that contains almost no Cl₂. The film is relatively unstable and can be easily removed during etching by means of ion bombardment, or after etching by a water rinse as it is soluble in water.

## Claims

1. A boron-halogen comprising plasma with additions of nitrogen for selective etching of at least two materials whereby the etch rate of the first material is reduced to almost zero by depositing a protective BxNy comprising layer onto the surface of said first material such that the etch rate of said first material drops down to zero and whereby deposition of said BxNy layer onto the second material is avoided.

2. The plasma composition of claims 1 wherein said boron-halogen compound is BCl₃.

3. The plasma composition of claim 1 and 2 further comprising an inert compound.

4. The plasma composition of all foregoing claims wherein the ratio of the boron-halogen compound to nitrogen is from 19:1 up to 5,6:1.

5. The plasma composition of all foregoing claims wherein the ratio of the boron-halogen compound to nitrogen is from 9:1 up to 6,7:1.

6. The plasma composition of all foregoing claims, whereby said second material is a material having a dielectric constant higher than 3,9 (high-k material).

7. The plasma composition of claim 6, whereby said second material is HfO₂.

8. The plasma composition of all foregoing claims, whereby said first material is silicon and the ratio of the boron-halogen compound to nitrogen is 9:1.

9. The plasma composition of claim 8, whereby said silicon is undoped polycrystalline silicon (poly-Si) or doped or polycrystalline silicon (poly-Si).

10. The plasma composition of claims 1 to 7 whereby said first material is silicon dioxide and the ratio of the boron-halogen compound to nitrogen is in the range of 9:1 up to 6.7:1.

11. The plasma composition of all foregoing claims, whereby said first and second material are part of a gate stack in a semiconductor device.

12. The plasma composition of all foregoing claims, whereby said first and second material are part of a Non-volatile Memory device (NVM).

13. The plasma composition of all foregoing claims, whereby said protective BxNy layer is at least partly removed during etching (using said plasma composition) by means of ion bombardment.

14. The plasma composition of claim 13, whereby ion bombardment is achieved by using a substrate bias during plasma etching which is different from zero.

15. The plasma composition of claim 14, whereby said substrate bias during plasma etching is in the range of -30v and -60V.

16. The plasma composition of all foregoing claims, whereby said protective BxNy layer is removed after etching by means of a wet rinse (e.g. by means of a water rinse).

17. The plasma composition of all forgoing claims, whereby the plasma power is in the range of 100W up to 1200W.

18. The plasma composition of claim 17, whereby the plasma power is around 450W.

19. The plasma composition of claims 1 to 18, whereby the pressure in the plasma is minimum 5mT and maximum 80mT.

20. The plasma composition of claims 1 to 19, whereby the pressure in the plasma is 5mT.

21. A method for etching a second material selective over a first material, said method comprising the steps of:
- applying a dry-etch step using a plasma whereby during the etching a protective and water-soluble film is deposited onto the first material such that the etch rate of said first material is dropped to almost zero and whereby almost no protective and water-soluble film is deposited onto the second material,
- removing said protective film from first material.

22. The method of claims 21 whereby said plasma comprises (or consist) a boron-halogen compound and nitrogen and wherein the ratio of the boron-halogen compound to nitrogen is from 19:1 up to 5.6:1.

23. The method of claims 22 whereby said boron-halogen compound is BCl₃.

24. The method of claims 20 to 23 whereby said protective and water-soluble film is **characterized** as a BxNy comprising film.

25. The method of claims 20 to 24, whereby the ratio of BCl₃ to nitrogen is from 9:1 up to 6,7:1.

26. The method of claims 20 to 25, whereby said second material is a high-k material.

27. The method of claims 20 to 26, whereby said second material is HfO₂.

28. The method of claims 20 to 27, whereby said first material is silicon and the ratio of the boron-halogen compound to nitrogen is 9:1.

29. The method of claim 28, whereby said silicon is undoped polycrystalline silicon (poly-Si) or doped or polycrystalline silicon (poly-Si).

30. The method of claims 20 to 29 whereby said first material is silicon dioxide and the ratio of the boron-halogen compound to nitrogen is in the range of 9:1 up to 6,7:1.

31. The method of claims 20 to 30, whereby said protective BxNy layer is removed during etching (using said plasma composition) by means of ion bombardment.

32. The method of claim 31, whereby ion bombardment is achieved by using a substrate bias during plasma etching which is different from zero.

33. The method of claim 32, whereby said substrate bias during plasma etching is in the range of -30v and -60V.

34. The method of claims 20 to 30, whereby said protective BxNy layer is removed after etching by means of a wet rinse (e.g. by means of a water rinse).

35. The method of claims 20 to 34, whereby the plasma power is in the range of 100W up to 1200W.

36. The method of claims 20 to 35, whereby the plasma power is around 450W.

37. The method of claims 20 to 36, whereby the pressure in the plasma is minimum 5mT and maximum 80mT.

38. The method of claims 20 to 37, whereby the pressure in the plasma is 5mT.

39. A reactive ion etching method for selectively removing a high-k material layer from a silicon (e.g. poly-Si) or silicon dioxide layer with a plasma composition according to any of claims 1 to 20.

40. A reactive ion etching method for selectively removing a high-k material layer from a silicon (e.g. poly-Si) or silicon dioxide layer with a plasma composition comprising BCl₃ and nitrogen in a ratio N₂/BCl₃ comprised between (about) 1:19 and (about) 1:5,6.

41. A method according to claim 39 or 40, wherein the plasma composition temperature for etching is less than (about) 100°C and preferably (about) 60°C.

42. A method according to any of claims 39 to 41, wherein said plasma composition further comprises helium or preferably argon.

43. A method according to claim 42, wherein said argon or helium is added up to 50 vol.%, based on the total volume of the plasma composition.

44. A method according to any of claims 39 to 43, wherein a bias is applied to said silicon (e.g. poly-Si) or silicon dioxide layer.

45. A method according to claim 44, wherein said bias is comprised between -30V and -60V.

46. A method according to any of claims 39 to 45, wherein the plasma power is comprised between 100W and 1200W, preferably is about 450W.

47. A method according to any of claims 39 to 46, wherein the pressure in the chamber is comprised between 0.666 Pa (5mT) and 10.665 Pa (80mT), preferably is about 0.666 Pa (5mT).

48. A method according to any of claims 39 to 47, wherein said high-k material layer is a metal oxide layer suitable for an integrated circuit or a semiconductor device.

49. A method according to claim 48, wherein said metal oxide is selected from the group consisting of HfO₂, ZrO₂, Al₂O₃, La₂O₃, Pr₂O₃, Ta₂O5, TiO₂, Y₂O₃, and Pr₂O₃.

50. A method according to claim 48, wherein said metal oxide is HfO₂.

51. A method for the manufacture of a semiconductor device, in particular a NVM device, comprising the steps of:
- providing a silicon (e.g. poly-Si) or SiO₂ substrate,
- depositing a high-k material layer on said substrate,
- forming a patterned gate electrode on said high-k material layer, and
- anisotropically etching said high-k material according to a method of any of claims 39 to 50.

52. A method according to claim 51, wherein said high-k material layer is a metal oxide layer suitable for said semiconductor device.

53. A method according to claim 52, wherein said metal oxide is selected from the group consisting of HfO₂, ZrO₂, Al₂O₃, La₂O₃, Pr₂O₃, Ta₂O5, TiO₂, Y₂O₃, and Pr₂O₃.

54. A method according to claim 53, wherein said metal oxide is HfO₂.

55. A method according to any of claims 51 to 54, wherein said patterned gate electrode comprises a germanium layer.

56. A method according to claim 55 whereby a passivating boron-nitride containing film is deposited on the sidewalls of said germanium layer, protecting the vertical profile of said gate electrode.

57. A method according to any of claims 51 to 56, further comprising a wet rinsing step, preferably a water rinsing step.

58. A method according to any of claims 51 to 57, wherein said semiconductor device is formed on semiconducting substrates selected from the group consisting of group IV materials, like silicon, or group III-V compounds, like gallium arsenide, or structured substrate such as silicon-on-insulator, strained silicon and silicon-germanium, or mixtures of such materials.

59. A method according to claim 58, wherein said semiconductor device is a NVM device.
